# FASCICULE DE BREVET EUROPEEN

(11) **EP 1 212 793 B1**
(45) Date de publication et mention de la délivrance du brevet: **26.07.2006**
(21) Numéro de dépôt: 00962614.4
(22) Date de dépôt: 12.09.2000
(51) Int. Cl.: H01L 21/768, H01L 23/532

(54) **PROCEDE DE REALISATION D'UNE CONNEXION EN CUIVRE**
VEFAHREN ZUR HERSTELLUNG EINER VERBINDUNG AUS KUPFER
METHOD FOR PRODUCING A COPPER CONNECTION

(30) Priorité: 14.09.1999 FR 9911468
(43) Date de publication de la demande: 12.06.2002
(73) Titulaire: COMMISSARIAT A L'ENERGIE ATOMIQUE, 75752 Paris Cédex 15 (FR); STMicroelectronics S.A., 92120 Montrouge (FR)
(72) Inventeur: MORAND, Yves, F-38000 Grenoble (FR); GOBIL, Yveline, F-38100 Grenoble (FR); DEMOLLIENS, Olivier, F-38120 Saint-Egrève (FR); ASSOUS, Myriam, F-38100 Grenoble (FR)
(74) Mandataire: Poulin, Gérard
(86) Numéro de dépôt international: PCT/FR2000/002515
(87) Numéro de publication internationale: WO 2001/020665

(56) Documents cités:
- EP-A- 0 798 778
- EP-A- 0 913 863
- WO-A-00/07236
- "LITHOGRAPHIC PATTERNS WITH A BARRIER LINER" IBM TECHNICAL DISCLOSURE BULLETIN,IBM CORP. NEW YORK,US, vol. 32, no. 10B, 1 mars 1990 (1990-03-01), pages 114-115, XP002035812 ISSN: 0018-8689

## Description

### Domaine technique

La présente invention concerne un procédé de réalisation d'une connexion en cuivre au travers d'une couche de matériau diélectrique d'un circuit intégré.

### Etat de la technique antérieure

L'amélioration des performances des circuits intégrés (vitesse, faible consommation) a nécessité un changement parmi certains matériaux qui étaient utilisés jusqu'à présent. Afin de diminuer la capacité existant entre les lignes conductrices réalisées dans une ou plusieurs couches de matériau diélectrique (structures, du type damascène), il est avantageux d'utiliser comme matériau diélectrique des matériaux à très faible constante diélectrique. Ces matériaux, désignés sous l'appellation "low-k" en anglais, comprennent des matériaux organiques et des matériaux poreux.

L'amélioration de ces performances passe aussi par l'emploi d'un métal plus conducteur que l'aluminium classiquement utilisé pour réaliser les lignes d'interconnexion. Le cuivre qui a une résistivité à peu près deux fois plus faible que l'aluminium dopé au cuivre, est apparu comme le meilleur candidat.

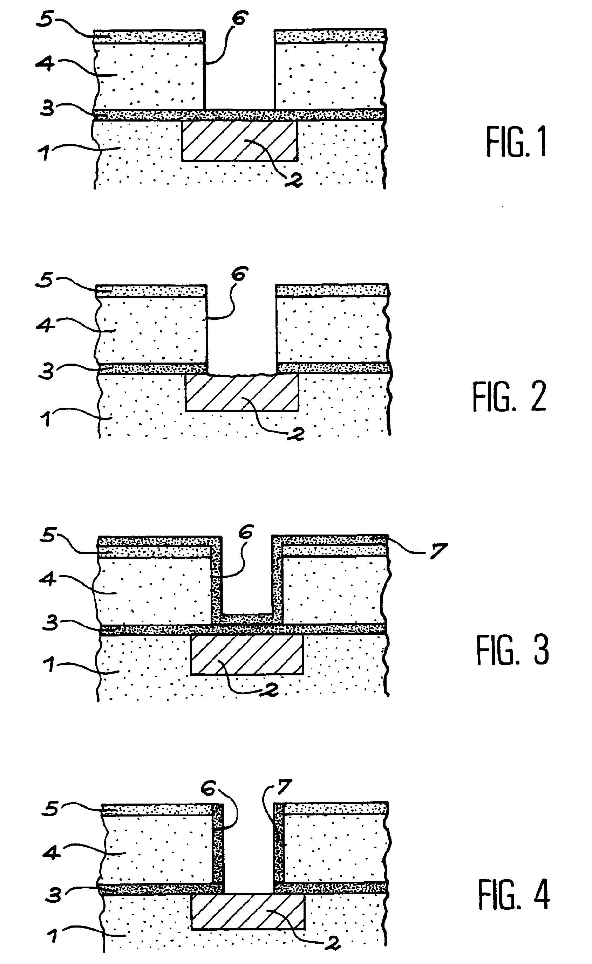

Les figures 1 et 2 montrent des étapes préparatoires à la réalisation d'une traversée (ou via) en cuivre dans le cas d'une structure simple damascène, selon l'art connu.

La figure 1 montre une couche de matériau diélectrique 1 recouvrant un substrat semiconducteur non représenté, cette couche comportant un élément de connexion 2 en cuivre affleurant à la surface de la couche de matériau diélectrique 1. Une couche d'encapsulation 3 est déposée sur la surface de la couche 1. Une couche de matériau diélectrique 4 est déposée sur la couche d'encapsulation 3. Une couche 5 de masque dur est déposée sur la couche 4 pour définir l'emplacement du trou traversant 6 obtenu par gravure. La couche d'encapsulation 3 peut être en SiN. Elle sert de couche de protection pour la couche de matériau diélectrique 4 en évitant la contamination de ce matériau diélectrique par le cuivre de l'élément de connexion 2. Elle sert aussi de couche d'arrêt à la gravure de la couche 4.

Comme le montre la figure 2, la couche d'encapsulation 3 est ensuite gravée dans le fond du trou 6, par exemple par un procédé de photolithographie, pour révéler l'élément de connexion en cuivre 2 à contacter.

Les étapes suivantes consisteront à pulvériser une couche de cuivre sur la couche de masque dur 5 en comblant le trou 6 pour prendre contact avec l'élément de connexion 2. Un polissage mécano-chimique du cuivre jusqu'à atteindre le niveau du masque dur permet d'éliminer le cuivre en excès et d'obtenir la traversée en cuivre.

A la fin de la gravure de la couche d'encapsulation 3, deux effets néfastes peuvent survenir. Le premier effet néfaste de cette gravure consiste en la pulvérisation de cuivre sur la paroi du trou 6 à partir de la surface révélée de l'élément de connexion 2. Le second effet néfaste consiste en une pollution de la surface de l'élément de connexion 2 en fonction des chimies de gravure utilisées.

Pour à la fois éliminer le cuivre sur la paroi des trous de traversée et restaurer l'état de surface du cuivre au fond des trous, il est connu d'utiliser des procédés de nettoyage en chimie humide et sèche. Par exemple, lorsque les couches de matériau diélectrique sont en SiO₂ ou en SiN, une séquence de nettoyage contenant HF dilué et mettant en oeuvre un plasma réactif contenant de l'hydrogène est efficace.

Lorsque le matériau diélectrique de la structure damascène est un matériau "low-k" plusieurs problèmes apparaissent. La pulvérisation de cuivre se produisant à la fin de la gravure de la couche d'encapsulation est susceptible de contaminer en profondeur la couche de matériau "low-k" (cas d'un polymère ou d'un matériau poreux). Il s'ensuit une dégradation des propriétés diélectriques locales (par exemple constante diélectrique, champ de claquage, courant de fuite) de ce matériau. Les procédés de nettoyage peuvent ne pas être utilisables à cause du risque d'attaque, voire de dégradation, du matériau diélectrique qu'ils risquent de provoquer. En outre, ces procédés de nettoyage ne permettent pas une décontamination dans le volume du matériau diélectrique. Dans le cas d'un matériau "low-k" tel que le SiLK, l'utilisation de fluorure d'hydrogène est à proscrire parce qu'il diffuse dans ce matériau et provoque le décollement du masque dur. A ce jour, il n'existe pas de solution de nettoyage du SiLK. L'homme de l'art essaie donc de ne pas le contaminer.

Par ailleurs, l'utilisation de matériau "low-k" pose généralement des problèmes de tenue mécanique des structures. Dans le cas de l'utilisation d'un diélectrique en polymère ou d'un diélectrique poreux, il peut se produire des désaxements des traversées du fait que le polymère est un matériau relativement mou ou, dans le cas d'un diélectrique poreux, lors du polissage mécano-chimique du cuivre.

EP-A-0 798 778 divulgue un procédé de réalisation d'une structure de connexion entre des conducteurs en cuivre situés dans des niveaux différents pour un dispositif semiconducteur. EP-A-0 913 863 divulgue un procédé de réalisation d'un film de connexion en cuivre pour un dispositif semiconducteur.

### Exposé de l'invention

L'invention apporte une solution aux problèmes énumérés ci-dessus.

Elle a pour objet un procédé de réalisation d'une connexion en cuivre avec un élément de connexion en cuivre d'un circuit intégré comportant une structure damascène, l'élément de connexion étant recouvert successivement d'une couche d'encapsulation et d'au moins une couche de matériau diélectrique à très faible constante diélectrique (matériau dit "low-k"), le procédé comprenant les étapes suivantes par l'ordre suivant:
- gravure de ladite couche de matériau diélectrique jusqu'à atteindre la couche d'encapsulation, pour obtenir un trou de connexion en vis-à-vis de l'élément de connexion,
- réalisation d'une couche de protection sur la paroi du trou de connexion, la couche de protection permettant d'éviter la contamination de la couche de matériau diélectrique par diffusion du cuivre,
- gravure de la couche d'encapsulation, au fond du trou de connexion, conduite de manière à révéler l'élément de connexion,
- remplissage du trou de connexion par du cuivre.

La couche de protection subsistant sur la paroi du trou empêche une contamination du matériau diélectrique. Elle permet un nettoyage sans risque du trou de connexion. Elle renforce la rigidité mécanique de la structure. Elle est aussi avantageuse si des espaceurs sont prévus mais qu'ils ne font pas barrière à la diffusion du cuivre.

Après l'étape de gravure anisotrope de la couche d'encapsulation et avant l'étape de remplissage du trou de connexion, le procédé peut comprendre une étape de nettoyage de la paroi et du fond du trou de connexion. Si la couche de protection est réalisée en un matériau qui fait barrière à la diffusion du cuivre, cette étape de nettoyage de la paroi du trou peut être omise.

La couche d'encapsulation peut être une couche de SiN.

La couche de matériau diélectrique à très faible constante diélectrique peut être en un matériau choisi parmi les polymères et les matériaux poreux.

Si la couche de matériau diélectrique est recouverte d'une couche de masque dur, le procédé peut comprendre une étape préliminaire de formation, dans le masque dur, d'une ouverture en vis-à-vis de l'élément de connexion, la gravure de la couche de matériau diélectrique se faisant au travers de l'ouverture du masque dur. La couche de masque dur peut être une couche d'un matériau choisi parmi l'oxyde de silicium, le carbure de silicium et le nitrure de silicium.

L'étape de dépôt d'une couche de protection peut consister au dépôt d'une couche de matériau métallique, de SiO₂, de SiCH, de TiN ou de SiN.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1 et 2, déjà décrites, illustrent des étapes préparatoires à la réalisation d'une traversée en cuivre dans le cas d'une structure simple damascène selon l'art connu ;
- les figures 3 et 4 illustrent des étapes préparatoires à la réalisation d'une traversée en cuivre dans le cas d'une structure simple damascène selon l'invention ;
- les figures 5 à 7 illustrent des étapes préparatoires à la réalisation d'une traversée en cuivre dans le cas d'une structure double damascène selon l'invention.

### Description détaillée de modes de réalisation de l'invention

Les figures 3 et 4 illustrent les étapes préparatoires à la réalisation d'une traversée en cuivre dans le cas d'une structure simple damascène selon l'invention. Cette structure étant analogue à celle décrite à la figure 1, les mêmes références sont utilisées pour désigner les mêmes éléments. Cependant, la couche de matériau diélectrique 4 est un matériau "low-k", par exemple un polymère à très faible constante diélectrique, c'est-à-dire de permittivité relative inférieure à 4,2, ou un matériau poreux.

Comme le montre la figure 3, une fois le trou 6 réalisé jusqu'à révéler la couche d'encapsulation 3, on dépose une mince couche de protection 7 qui épouse la surface libre de la structure damascène. La paroi du trou 6 et son fond sont ainsi recouverts de la couche de protection. Cette couche de protection est par exemple en SiN.

L'étape suivante consiste à réaliser une gravure anisotrope de la couche de protection 7. La gravure est prévue pour attaquer les parties représentées horizontalement sur la figure 3 et pour laisser intactes les parties représentées verticalement. Comme le montre la figure 4, il ne subsiste de la couche de protection 7 que la partie de cette couche recouvrant la paroi du trou 6. La figure 4 montre aussi que la partie de la couche d'encapsulation 3 située au fond du trou 6 a été éliminée lors de la gravure révélant ainsi l'élément de connexion 2 en cuivre. Si les couches de masque dur et d'encapsulation sont réalisées avec des matériaux différents, il peut être nécessaire d'utiliser deux gravures différentes.

La partie de la couche de protection 7 recouvrant la paroi du trou 6 protège efficacement le matériau diélectrique de la couche 4 lorsque la gravure révèle l'élément de connexion 2 et pendant le nettoyage du trou 6.

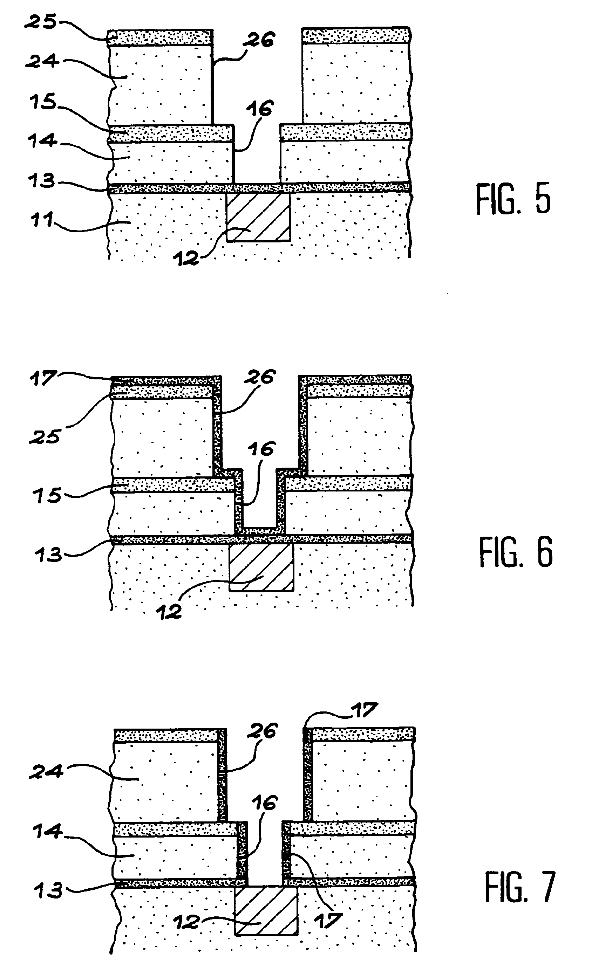

Les figures 5 à 7 illustrent des étapes préparatoires à la réalisation d'une traversée en cuivre dans le cas d'une structure double damascène selon l'invention.

La figure 5 montre une couche de matériau diélectrique 11 comportant un élément de connexion 12 en cuivre affleurant à la surface de la couche 11. Une couche d'encapsulation 13 est déposée sur la surface de la couche 11. Une première couche de matériau diélectrique 14 est déposée sur la couche d'encapsulation 13. Une couche 15 servant de masque dur pour la première couche de matériau diélectrique 14 est ensuite déposée. Sur la couche de masque dur 15 on dépose une deuxième couche de matériau diélectrique 24 puis une couche 25 servant de masque dur pour la deuxième couche de matériau diélectrique 24.

La couche d'encapsulation 13 peut être en SiN, les couches 14 et 24 peuvent être en SiLK, les couches de masque dur 15 et 25 peuvent être en SiO₂ ou en nitrure de silicium.

De manière connue, les couches de matériau diélectrique 14 et 24 sont gravées au travers d'ouvertures réalisées dans leurs masques durs 15 et 25 pour obtenir des trous superposés 16 et 26.

Comme le montre la figure 6, une fois les trous 16 et 26 réalisés jusqu'à révéler la couche d'encapsulation 13, on dépose une mince couche de protection 17 qui épouse la surface libre de la structure double damascène. La couche de protection 17 peut être en SiN ou en TiN.

L'étape suivante consiste à réaliser une gravure anisotrope de la couche de protection 17. La gravure est prévue pour attaquer les parties représentées horizontalement sur la figure 6 et pour laisser intactes les parties représentées verticalement. Comme le montre la figure 7, il ne subsiste de la couche de protection 17 que les parties de cette couche recouvrant les parois des trous 16 et 26. La figure 7 montre aussi que la partie de la couche d'encapsulation 13 située au fond du trou 16 a été éliminée lors de la gravure révélant ainsi l'élément de connexion 12 en cuivre.

Les parties de la couche de protection 17 recouvrant les parois des trous 16 et 26 protègent efficacement le matériau diélectrique des couches 14 et 24 lorsque la gravure révèle l'élément de connexion 12 et pendant le nettoyage des trous 16 et 26.

La couche 15 n'est pas obligatoire. Cependant, elle permet de mieux maîtriser la profondeur de la ligne et les dimensions du trou. Si la couche 15 a des propriétés de barrière au cuivre, le fond du trou 26 (de forme annulaire) ne nécessite pas d'autre protection.

## Revendications

1. Procédé de réalisation d'une connexion en cuivre avec un élément de connexion en cuivre (2;12) d'un circuit intégré comportant une structure damascène, l'élément de connexion étant recouvert successivement d'une couche d'encapsulation (3;13) et d'au moins une couche (4;14,24) de matériau diélectrique à très faible constante diélectrique (matériau dit "low-k"), le procédé comprenant les étapes suivantes par l'ordre suivant :
- gravure de ladite couche de matériau diélectrique (4;14,24) jusqu'à atteindre la couche d'encapsulation (3;13), pour obtenir un trou de connexion (6;16,26) en vis-à-vis de l'élément de connexion,
- réalisation d'une couche de protection sur la paroi du trou de connexion, la couche de protection permettant d'éviter la contamination de la couche de matériau diélectrique par diffusion du cuivre,
- gravure de la couche d'encapsulation (3;13), au fond du trou de connexion, conduite de manière à révéler l'élément de connexion (2;12),
- remplissage du trou de connexion (6;16,26) par du cuivre.

2. Procédé selon la revendication 1, **caractérisé en ce que**, après l'étape de gravure de la couche d'encapsulation (3;13) et avant l'étape de remplissage du trou de connexion (6;16,26), le procédé comprend une étape de nettoyage du trou de connexion.

3. Procédé selon la revendication 1, **caractérisé en ce que** la couche d'encapsulation (3;13) est une couche de SiN.

4. Procédé selon la revendication 1, **caractérisé en ce que** ladite couche de matériau diélectrique (4;14,24) à très faible constante diélectrique est en un matériau choisi parmi les polymères et les matériaux poreux.

5. Procédé selon la revendication 1, **caractérisé en ce que** la couche de matériau diélectrique (4 ; 14, 24) étant recouverte d'une couche de masque dur (5 ; 15, 25), le procédé comprend une étape préliminaire de formation, dans le masque dur, d'une ouverture en vis-à-vis de l'élément de connexion (2 ; 12), la gravure de la couche de matériau diélectrique se faisant au travers de l'ouverture du masque dur.

6. Procédé selon la revendication 5, **caractérisé en ce que** la couche de masque dur (5;15,25) est une couche d'un matériau choisi parmi l'oxyde de silicium, le carbure de silicium et le nitrure de silicium.

7. Procédé selon la revendication 1, **caractérisé en ce que** l'étape de dépôt d'une couche de protection (7;17) consiste au dépôt d'une couche d'un matériau métallique.

8. Procédé selon la revendication 1, **caractérisé en ce que** l'étape de dépôt d'une couche de protection (7;17) consiste au dépôt d'une couche d'un matériau choisi parmi SiO₂, SiCH, TiN et SiN.

## Claims

1. Process for making a copper connection with a copper connection element (2, 12) in an integrated circuit comprising a damascene structure, with the connection element being covered successively with an encapsulation layer (3; 13) and at least one layer (4; 14, 24) of dielectric material with a very low dielectric constant (called a "low-k" material), the process comprises the following steps in the following order:
- etching said layer of dielectric material (4; 14, 24) until the encapsulation layer (3; 13) is reached in order to obtain a connection hole (6; 16, 26), opposite the connection element,
- forming a protective layer on the walls of the connection hole, with the protective layer enabling contamination of the layer of dielectric material by diffusion of copper to be avoided,
- etching the encapsulation layer (3; 13), at the bottom of the connection hole, in such a way as to reveal the connection element (2; 12),
- filling the connection hole (6; 16, 26) with copper.

2. Process according to claim 1, **characterized in that**, after the etching of the encapsulation layer (3; 13) and before the filling of the connection hole (6; 16, 26), the process comprises a step of cleaning the connection hole.

3. Process according to claim 1, **characterized in that** the encapsulation layer (3; 13) is a layer of SiN.

4. Process according to claim 1, **characterized in that** said layer of dielectric material (4; 14, 24) with a very low dielectric constant is a material chosen among polymers and porous materials.

5. Process according to claim 1, **characterized in that** the layer of dielectric material (4; 14, 24) is covered with a hard masking layer (5; 15, 25), and the process comprises a preliminary step of forming, in the hard masking layer, an opening opposite the connection element (2; 12), with the etching of the layer of dielectric material being achieved through an opening in the hard masking layer.

6. Process according to claim 5, **characterized in that** the hard masking layer (5; 15, 25) is a layer of material chosen from silicon oxide, silicon carbide and silicon nitride.

7. Process according to claim 1, **characterized in that** the step of depositing a protective layer (7; 17) consists in depositing a layer of metallic material.

8. Process according to claim 1, **characterized in that** the step of depositing a protective layer (7; 17) consists in depositing a layer of material chosen among SiO₂, SiCH, TiN and SiN.

## Patentansprüche

1. Verfahren zum Herstellen einer Verbindung aus Kupfer mit einem Kupfer-Verbindungselement (2; 12) einer integrierten Schaltung mit einer damaszenen Struktur, wobei das Verbindungselement sukzessive überzogen wird mit einer Verkapselungsschicht (3: 13) und wenigstens einer Schicht (4; 14, 24) aus dielektrischem Material mit sehr niedriger dielektrischer Konstante (sogenanntem "low-k"-Material), und das Verfahren dabei die folgenden Schritte in folgender Reihenfolge umfasst:
- Ätzen der genannten Schicht aus dielektrischem Material (4; 14, 24), bis die Verkapselungsschicht (3; 13) erreicht ist, um gegenüber dem Verbindungselement ein Verbindungsloch (6; 16, 26) herzustellen,
- Erzeugen einer Schutzschicht auf der Wand der Verbindungslochs, wobei die Schutzschicht ermöglicht, die Kontamination der Schicht aus dielektrischem Material durch Diffusion des Kupfers zu vermeiden,
- Ätzen der Verkapselungsschicht (3; 13) auf dem Boden des Vorbindungstochs bis zum Verbindungselement (2; 12),
- Füllen des Verbindungsiochs (6; 16, 26) mit Kupfer.

2. Verfahren nach Anspruch 1, **dadurch gekennzeichnet, dass** das Verfahren - nach dem Ätzschritt der Verkapselungsschicht (3; 13) und vor dem Füllschritt des Verbindungslochs (6; 16, 26) - einen Schritt zur Reinigung des Verbindungslochs umfasst.

3. Verfahren nach Anspruch 1, **dadurch gekennzeichnet, dass** die Verkapselungsschicht (3; 13) eine SiN-Schicht ist.

4. Verfahren nach Anspruch 1, **dadurch gekennzeichnet, dass** die Schicht (4; 14, 24) aus dielektrischem Material mit sehr niedriger dielektrischer Konstante aus einem Material ist, das unter den polymeren und den porösen Materialien ausgewählt wird.

5. Verfahren nach Anspruch 1, **dadurch gekennzeichnet, dass** die Schicht (4; 14, 24) aus dielektrischem Material mit einer harten Maskenschicht (5; 15, 25) überzogen wird und das Verfahren einen Vorbereitungsschritt umfasst, um in der harten Maske eine Öffnung gegenüber dem Verbindungselement (2; 12) herzustellen, durch die hindurch die Schicht aus dielektrischem Material geätzt wird.

6. Verfahren nach Anspruch 5, **dadurch gekennzeichnet, dass** die harte Maskenschicht (5; 15, 25) eine Schicht aus einem Material ist, das ausgewählt wird unter Silicium, Siliciumkarbid und Siliciumnitrid.

7. Verfahren nach Anspruch 1, **dadurch gekennzeichnet, dass** der Schritt zur Abscheidung einer Schutzmaske (7; 17) aus dem Abscheiden einer Schicht aus einem metallischen Material bestcht.

8. Verfahren nach Anspruch 1, **dadurch gekennzeichnet, dass** der Schritt zur Abscheidung einer Schutzmaske (7; 17) aus dem Abscheiden einer Schicht aus einem unter SiO₂, SiCH, TiN und SiN ausgewählten Material besteht.
